(19) **Europäisches Patentamt / European Patent Office / Office européen des brevets**

(11) **EP 4 447 485 B1**

(12) **FASCICULE DE BREVET EUROPEEN**

(45) Date de publication et mention
de la délivrance du brevet:
**18.02.2026 Bulletin 2026/08**

(21) Numéro de dépôt: **24170115.0**

(22) Date de dépôt: **12.04.2024**

(51) Classification Internationale des Brevets (IPC):
*H04R 3/04* (2006.01)     *H04S 7/00* (2006.01)

(52) Classification Coopérative des Brevets (CPC):
**H04R 3/04; H03G 3/32; H03G 5/165;**
H04R 2499/13; H04S 7/30

(54) **DISPOSITIF ET PROCEDE D'EGALISATION DE SIGNAL AUDIO POUR VEHICULE METTANT EN OEUVRE UN BUS DE COMMUNICATION DE DONNEES**

VORRICHTUNG UND VERFAHREN ZUM ENTZERREN EINES AUDIOSIGNALS FÜR EIN FAHRZEUG MIT EINEM DATENKOMMUNIKATIONSBUS

DEVICE AND METHOD FOR EQUALIZING AN AUDIO SIGNAL FOR A VEHICLE USING A DATA COMMUNICATION BUS

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **14.04.2023 FR 2303775**

(43) Date de publication de la demande:
**16.10.2024 Bulletin 2024/42**

(73) Titulaire: **Arkamys**
**92300 Levallois-Perret (FR)**

(72) Inventeurs:
• **FADILI, Moulay**
**92300 LEVALLOIS-PERRET (FR)**
• **MAÏ, Van Khanh**
**92300 Levallois-Perret (FR)**

(74) Mandataire: **Cabinet Netter**
**36, avenue Hoche**
**75008 Paris (FR)**

(56) Documents cités:
**EP-A1- 2 693 636**     **US-A1- 2005 213 776**
**US-A1- 2007 242 837**

• **CHRISTOPH ET AL: "Noise Dependent Equalization Control", CONFERENCE: 48TH INTERNATIONAL CONFERENCE: AUTOMOTIVE AUDIO; 20120901, AES, 60 EAST 42ND STREET, ROOM 2520 NEW YORK 10165-2520, USA, 21 September 2012 (2012-09-21), XP040574719**

**Description**

L'invention concerne le domaine du traitement de signal audio dans un véhicule, et plus particulièrement à l'égalisation d'un tel signal audio dans un environnement pouvant être bruyant, notamment lorsque le bruit en question est susceptible de varier dans le temps.

L'effet de masquage d'un premier signal audio par un deuxième signal audio est le processus par lequel le seuil d'audition pour le premier signal se trouve relevé par la présence du deuxième signal. En d'autres termes, le masquage spectral se produit dans une bande de fréquence donnée lorsque la présence du deuxième signal ne permet pas la détection du premier signal d'amplitude inférieure dans la même bande de fréquence.

Dans une voiture, cet effet est généralement créé par le bruit aérodynamique lié au roulement de la voiture, ainsi que par le bruit du moteur. En présence de bruit, la perception de l'équilibre spectral de la musique diffusé dans l'habitacle de la voiture peut alors être altérée car certaines fréquences seront masquées.

L'équilibre tonal perçu dépend de la différence entre le niveau sonore de diffusion et le seuil de masquage. Comme les signaux musicaux présentent une dynamique donnée (différence entre les amplitudes les plus élevées et les plus basses), pour une valeur de niveau moyen donnée en dB SPL (pour *"Sound Pressure Level"* en anglais) proche du seuil, certaines composantes du signal seront perçues et d'autres seront masquées.

Afin d'éviter le phénomène de masquage et de préserver l'équilibre tonal perçu, il est nécessaire d'augmenter certaines fréquences du signal audio diffusé au-delà du seuil de masquage. L'isolation acoustique n'étant pas suffisante, des techniques de traitement du signal ont été développées pour réaliser des filtres de masquage permettant de compenser le phénomène de masquage.

Dans l'état de l'art, deux types de techniques sont classiquement mises en œuvre. Une première technique, dite SDVC (pour *"Speed Dependent Volume Control"* en anglais), consiste à ajouter un gain calculé à partir d'une table de vitesse pour augmenter le volume sonore du signal audio (i.e., l'ensemble du signal audio) au-dessus du seuil de masquage. Une deuxième technique, proposée dans US2005213776A1 et EP2693636A1, dite SDEC (pour *"Speed Dependent Equalization Control"* en anglais), consiste à appliquer un filtre en plateaux basses fréquences (ou *"low shelf filter"* en anglais) dont les paramètres dépendent de la vitesse et de l'atténuation globale du système.

Ces deux techniques présentent l'avantage d'être peu gourmandes en puissance de calcul, ce qui est particulièrement crucial dans un environnement automobile, tant du point de vue du coût que du point de vue de la facilité d'intégration.

Cependant, le bruit de fond dans un véhicule du type voiture à plusieurs sources parmi lesquelles on peut citer à titre d'exemples :

- la configuration du véhicule lui-même liée à son isolation acoustique, son aérodynamique, le type de pneus, de moteur, etc. ;
- certaines fonctionnalités du véhicule qui peuvent modifier le bruit de fond tel le système HVAC (pour *"Heating, Ventilation and Air-Conditioning"* en anglais, ou système de chauffage, ventilation et climatisation), l'activation / désactivation du moteur thermique des voitures hybrides, etc. ;
- les bruits de roulement et les bruits aérodynamiques qui augmentent avec la vitesse de la voiture ;
- la nature de la surface de la route, les routes ou chaussées goudronnées à gros grains étant plus bruyantes que les routes goudronnées lisses ; et
- l'environnement, les routes de campagne ouvertes étant moins bruyantes que les tunnels. La pluie et le vent augmentent également le bruit de fond dans le véhicule.

Le bruit de fond peut généralement être décrit comme un bruit à large bande avec une décroissance de 6 dB par octave dans les hautes fréquences. Cependant, en fonction des sources de bruit listées ci-dessus, cette définition peut ne pas être suffisante pour décrire les phénomènes de masquage rencontrés en pratique. Par exemple, en présence de pluie les hautes fréquences peuvent également être masquées. De même, en fonction de la nature du véhicule et de sa vitesse, les bandes de fréquences effectivement masquées peuvent changer dans le temps.

Face à de tels effets de masquage variables, on peut observer que la fonction SDVC augmente le niveau de l'ensemble du signal lorsque la vitesse augmente. Cependant, la perception du signal audiofréquences diffusé n'est pas linéaire autour du seuil de masquage (Par exemple, les hautes fréquences peuvent être mieux perçues que les basses fréquences). Ainsi, au fur et à mesure que la vitesse augmente, la fonction SDVC augmente le niveau de l'ensemble du signal alors que ce n'est pas forcément nécessaire pour toutes les fréquences.

Pour sa part, la fonction SDEC introduit un certain traitement spectral pour éviter l'effet précédent. En amplifiant le signal avec un filtre en plateaux basses fréquences, la fonction SDEC garantit que pour un profil de bruit classique (i.e., présentant une décroissance de 6 dB par octave dans les hautes fréquences), les basses fréquences sont augmentées au-dessus du seuil de masquage et l'équilibre spectral perçu est préservé. L'hypothèse est dans ce cas que le profil de bruit de fond ne dépend que de la vitesse du véhicule. Mais comme décrit ci-dessus, un tel profil peut changer radicalement et de manière imprévisible, par exemple avec la surface de la route ou l'environnement.

Pour cette raison, la Demanderesse a développé une égalisation par masquage appelée NDEC (pour *"Noise Dependent EQ Control"* en anglais), qui consiste en un contrôle d'égalisation en fonction de bruit capturé par un capteur acoustique au sein du véhicule. Ce traitement repose sur un algorithme qui analyse le bruit capturé par un microphone pour en déduire le spectre du bruit en temps réel et appliquer un filtre de compensation sur le signal audio. Il présente le grand avantage de présenter une grande adaptabilité aux différents bruits. Cependant, il présente de nombreux désavantages, comme la nécessité d'utiliser un microphone, une très forte consommation en ressources de calcul et de mémoire, et la nécessité d'un traitement dédié pour la voix.

Actuellement, il est donc nécessaire de faire un choix entre une égalisation par masquage simple, mais peu efficace compte tenu des diverses sources de bruit, ou une égalisation efficace, mais extrêmement coûteuse et complexe à mettre en œuvre.

L'invention vient améliorer la situation. À cet effet, elle propose un dispositif d'égalisation de signal audio pour véhicule mettant en œuvre un bus de communication de données comprenant :

- une mémoire agencée pour stocker des jeux de données de filtre de vitesse comprenant des triplets associant une valeur de vitesse et une valeur de gain associée à des coefficients pour définir un filtre de masquage de vitesse, et des jeux de données de filtre fonctionnel comprenant des triplets associant une valeur de régime moteur ou une valeur de ventilation et une valeur de gain associée à des coefficients pour définir un filtre de masquage de moteur ou de ventilation,

- un collecteur agencé pour recevoir au moins deux paramètres accessibles sur le bus de communication, lesquels paramètres désignent la vitesse du véhicule et au moins un paramètre fonctionnel choisi dans le groupe comprenant le régime moteur du véhicule et un jeu de données de ventilation, et

- un calculateur agencé pour recevoir en entrée une valeur de marge sonore, ainsi que lesdits au moins deux paramètres accessibles sur le bus de communication, pour en tirer au moins un jeu de données de filtre de vitesse et au moins un jeu de données de filtre fonctionnel et pour les combiner en un filtre d'égalisation de masquage à appliquer à un signal audio.

Ce dispositif est particulièrement avantageux car il permet de mettre en œuvre une égalisation qui est efficace pour les principales sources de bruit, avec un coût de mise en œuvre qui reste raisonnable, et qui s'appuie sur une architecture présente dans tous les véhicules, sans ajout matériel.

Selon divers modes de réalisation, l'invention peut présenter une ou plusieurs des caractéristiques suivantes :

- le calculateur est agencé pour déterminer un jeu de données de filtre de vitesse et un jeu de données de filtre fonctionnel dans la mémoire à partir des au moins deux paramètres déterminés par le collecteur, pour calculer une valeur de gain de vitesse à partir d'au moins la valeur de gain du jeu de données de filtre de vitesse déterminé et de la valeur de marge sonore et pour en tirer un jeu de données de filtre de vitesse, et pour déterminer une valeur de gain fonctionnel à partir d'au moins la valeur de gain du jeu de données de filtre fonctionnel déterminé, de la valeur de gain de vitesse et de la valeur de marge sonore et pour en tirer un jeu de données de filtre fonctionnel,

- le calculateur est agencé pour calculer la valeur de gain de vitesse en retenant le minimum entre la valeur de gain du jeu de données de filtre de vitesse déterminé et la valeur de marge sonore, et pour calculer la valeur de gain fonctionnel en retenant le minimum entre la valeur de gain du jeu de données de filtre fonctionnel déterminé et la différence entre la valeur de marge sonore et la valeur de gain de vitesse,

- le calculateur est agencé, en présence d'un paramètre fonctionnel de régime moteur et d'un paramètre fonctionnel de jeu de données de ventilation pour déterminer un jeu de données de filtre fonctionnel principal et un deuxième jeu de données de filtre fonctionnel secondaire à partir du paramètre fonctionnel de régime moteur et du paramètre fonctionnel de jeu de données de ventilation, la valeur de gain du jeu de données de filtre fonctionnel principal étant supérieure à la valeur de gain du jeu de données de filtre fonctionnel secondaire, pour déterminer une première valeur de gain fonctionnel à partir d'au moins la valeur de gain du jeu de données de filtre fonctionnel principal, de la valeur de gain de vitesse et de la valeur de marge sonore et en tirer un premier jeu de données de filtre fonctionnel, pour déterminer une deuxième valeur de gain fonctionnel à partir d'au moins la valeur de gain du jeu de données de filtre fonctionnel secondaire, de la première valeur de gain fonctionnel, de la valeur de gain de vitesse et de la valeur de marge sonore et en tirer un deuxième jeu de données de filtre fonctionnel, et pour calculer une valeur de gain fonctionnel et un jeu de données de filtre fonctionnel à partir de la première valeur de gain fonctionnel, de la deuxième valeur de gain fonctionnel, du premier jeu de données de filtre fonctionnel et du deuxième jeu de données de filtre fonctionnel,

- le calculateur est agencé, lorsque le paramètre de vitesse est inférieur à un seuil choisi pour déterminer un jeu de données de filtre fonctionnel et un jeu de données de filtre de vitesse dans la mémoire à partir des au moins deux paramètres déterminés par le collecteur, pour déterminer une valeur de gain fonctionnel à partir d'au moins la valeur de gain du jeu de données de filtre fonctionnel déterminé et de la valeur de marge sonore et pour en tirer un jeu de données de filtre fonctionnel à partir de la valeur de gain fonctionnel, et pour déterminer une valeur de gain de vitesse à partir d'au moins la valeur de gain du jeu de données de filtre de vitesse déterminé, de la valeur de gain fonctionnel et de la valeur de marge sonore et pour en tirer un jeu de données de filtre de vitesse à partir du gain de vitesse,

- le calculateur est agencé pour calculer la valeur de gain fonctionnel en retenant le minimum entre la valeur de gain du jeu de données de filtre fonctionnel déterminé et la valeur de marge sonore, et pour calculer la valeur de gain de vitesse en retenant le minimum entre la valeur de gain du jeu de données de filtre de vitesse déterminé et la différence entre la valeur de marge sonore et la valeur de gain fonctionnel,
- le calculateur est agencé, en présence d'un paramètre fonctionnel de régime moteur et d'un paramètre fonctionnel de jeu de données de ventilation pour déterminer un jeu de données de filtre fonctionnel principal et un jeu de données de filtre fonctionnel secondaire à partir du paramètre fonctionnel de régime moteur et du paramètre fonctionnel de jeu de données de ventilation, la valeur de gain du jeu de données de filtre fonctionnel principal étant supérieure à la valeur de gain du jeu de données de filtre fonctionnel secondaire, pour déterminer une première valeur de gain fonctionnel à partir d'au moins la valeur de gain du jeu de données de filtre fonctionnel principal et de la valeur de marge sonore et en tirer un premier jeu de données de filtre fonctionnel, pour déterminer une deuxième valeur de gain fonctionnel à partir d'au moins la valeur de gain du jeu de données de filtre fonctionnel secondaire, de la première valeur de gain fonctionnel et de la valeur de marge sonore et en tirer un deuxième jeu de données de filtre fonctionnel, et pour calculer une valeur de gain fonctionnel et un jeu de données de filtre fonctionnel à partir de la première valeur de gain fonctionnel, de la deuxième valeur de gain fonctionnel, du premier jeu de données de filtre fonctionnel et du deuxième jeu de données de filtre fonctionnel, et
- le calculateur est agencé pour appliquer un filtre passe-haut au filtre d'égalisation de masquage en fonction de la différence entre la marge sonore, la valeur de gain de vitesse et la valeur de gain fonctionnel.

L'invention concerne également un procédé d'égalisation de signal audio pour véhicule mettant en œuvre un bus de communication de données comprenant :

a) stocker des jeux de données de filtre de vitesse comprenant des triplets associant une valeur de vitesse et une valeur de gain associée à des coefficients pour définir un filtre de masquage de vitesse, et des jeux de données de filtre fonctionnel comprenant des triplets associant une valeur de régime moteur ou une valeur de ventilation et une valeur de gain associée à des coefficients pour définir un filtre de masquage de moteur ou de ventilation,
b) recevoir au moins deux paramètres accessibles sur le bus de communication de données, lesquels paramètres désignent la vitesse du véhicule et au moins un paramètre fonctionnel choisi dans le groupe comprenant le régime moteur du véhicule et un jeu de données de ventilation, et une valeur de marge sonore, et
c) tirer des paramètres de l'étape b) et de la valeur de marge sonore au moins un jeu de données de filtre de vitesse et au moins un jeu de données de filtre fonctionnel et pour les combiner en un filtre d'égalisation de masquage à appliquer à un signal audio.

Selon divers modes de réalisation, l'invention peut présenter une ou plusieurs des caractéristiques suivantes :

- l'opération c) comprend c1) déterminer un jeu de données de filtre de vitesse et un jeu de données de filtre fonctionnel à partir des au moins deux paramètres déterminés par le collecteur, c2) calculer une valeur de gain de vitesse à partir d'au moins la valeur de gain du jeu de données de filtre de vitesse déterminé et de la valeur de marge sonore et en tirer un jeu de données de filtre de vitesse, et c3) déterminer une valeur de gain fonctionnel à partir d'au moins la valeur de gain du jeu de données de filtre fonctionnel déterminé, de la valeur de gain de vitesse et de la valeur de marge sonore et en tirer un jeu de données de filtre fonctionnel,
- l'opération c2) comprend calculer la valeur de gain de vitesse en retenant le minimum entre la valeur de gain du jeu de données de filtre de vitesse déterminé, la valeur de marge sonore, et l'opération c3) comprend calculer la valeur de gain fonctionnel en retenant le minimum entre la valeur de gain du jeu de données de filtre fonctionnel déterminé, la différence entre la valeur de marge sonore et la valeur de gain de vitesse,
- lorsque l'opération b) retourne un paramètre fonctionnel de régime moteur et un paramètre fonctionnel de jeu de données de ventilation, l'opération c3) comprend c3a) déterminer un jeu de données de filtre fonctionnel principal et un deuxième jeu de données de filtre fonctionnel secondaire à partir du paramètre fonctionnel de régime moteur et du paramètre fonctionnel de jeu de données de ventilation, la valeur de gain du jeu de données de filtre fonctionnel principal étant supérieure à la valeur de gain du jeu de données de filtre fonctionnel secondaire, c3b) déterminer une première valeur de gain fonctionnel à partir d'au moins la valeur de gain du jeu de données de filtre fonctionnel principal, de la valeur de gain de vitesse et de la valeur de marge sonore et en tirer un premier jeu de données de filtre fonctionnel, c3c) déterminer une deuxième valeur de gain fonctionnel à partir d'au moins la valeur de gain du jeu de données de filtre fonctionnel secondaire, de la première valeur de gain fonctionnel, de la valeur de gain de vitesse et de la valeur de marge sonore et en tirer un deuxième jeu de données de filtre fonctionnel, et c3d) calculer une valeur de gain fonctionnel et un jeu de données de filtre fonctionnel à partir de la première valeur de gain fonctionnel, de la deuxième valeur de gain fonctionnel, du premier jeu de données de filtre fonctionnel et du deuxième jeu de données de filtre fonctionnel,

- lorsque le paramètre de vitesse de l'opération b) est inférieur à un seuil choisi, l'opération c) comprend c1) déterminer un jeu de données de filtre fonctionnel et un jeu de données de filtre de vitesse dans la mémoire à partir des au moins deux paramètres déterminés par le collecteur, c2) déterminer une valeur de gain fonctionnel à partir d'au moins la valeur de gain du jeu de données de filtre fonctionnel déterminé et de la valeur de marge sonore et en tirer un jeu de données de filtre fonctionnel à partir de la valeur de gain fonctionnel, et c3) déterminer une valeur de gain de vitesse à partir d'au moins la valeur de gain du jeu de données de filtre de vitesse déterminé, de la valeur de gain fonctionnel et de la valeur de marge sonore et en tirer un jeu de données de filtre de vitesse à partir du gain de vitesse,

- l'opération c1) comprend calculer la valeur de gain fonctionnel en retenant le minimum entre la valeur de gain du jeu de données de filtre fonctionnel déterminé, la valeur de marge sonore, et l'opération c2) comprend calculer la valeur de gain de vitesse en retenant le minimum entre la valeur de gain du jeu de données de filtre de vitesse déterminé, la différence entre la valeur de marge sonore et la valeur de gain fonctionnel,

- lorsque l'opération b) retourne un paramètre fonctionnel de régime moteur et un paramètre fonctionnel de jeu de données de ventilation, l'opération c2) comprend c2a) déterminer un jeu de données de filtre fonctionnel principal et un jeu de données de filtre fonctionnel secondaire à partir du paramètre fonctionnel de régime moteur et du paramètre fonctionnel de jeu de données de ventilation, la valeur de gain du jeu de données de filtre fonctionnel principal étant supérieure à la valeur de gain du jeu de données de filtre fonctionnel secondaire, c2b) déterminer une première valeur de gain fonctionnel à partir d'au moins la valeur de gain du jeu de données de filtre fonctionnel principal et de la valeur de marge sonore et en tirer un premier jeu de données de filtre fonctionnel, c2c) déterminer une deuxième valeur de gain fonctionnel à partir d'au moins la valeur de gain du jeu de données de filtre fonctionnel secondaire, de la première valeur de gain fonctionnel et de la valeur de marge sonore et en tirer un deuxième jeu de données de filtre fonctionnel, et c2d) calculer une valeur de gain fonctionnel et un jeu de données de filtre fonctionnel à partir de la première valeur de gain fonctionnel, de la deuxième valeur de gain fonctionnel, du premier jeu de données de filtre fonctionnel et du deuxième jeu de données de filtre fonctionnel, et

- le procédé comprenant en outre l'opération d) appliquer un filtre passe-haut au filtre d'égalisation de masquage en fonction de la différence entre la marge sonore, la valeur de gain de vitesse et la valeur de gain fonctionnel.

L'invention concerne également un programme informatique comprenant des instructions pour exécuter le procédé selon l'invention, un support de stockage de données sur lequel est enregistré un tel programme informatique et un système informatique comprenant un processeur couplé à une mémoire, la mémoire ayant enregistré un tel programme informatique.

D'autres caractéristiques et avantages de l'invention apparaîtront mieux à la lecture de la description qui suit, tirée d'exemples donnés à titre illustratif et non limitatif, tirés des dessins sur lesquels :

- la [Fig.1] représente un système de diffusion d'un signal audio dans un véhicule mettant en œuvre l'invention,

- la [Fig.2] représente un exemple de structure de dispositif permettant la mise en œuvre l'égalisation par masquage dans le système de la [Fig.1],
de réalisation de l'invention,

- la [Fig.3] représente un premier mode de réalisation d'une égalisation par le dispositif de la [Fig.2],

- la [Fig.4] représente un premier exemple de mise en œuvre de l'égalisation de la [Fig.3],

- la [Fig.5] représente un deuxième exemple de mise en œuvre de l'égalisation de la [Fig.3],

- la [Fig.6] représente un troisième exemple de mise en œuvre de l'égalisation de la [Fig.3], et

- la [Fig.7] représente un deuxième mode de réalisation d'une égalisation par le dispositif de la [Fig.2].

Les dessins et la description ci-après contiennent, pour l'essentiel, des éléments de caractère certain. Ils pourront donc non seulement servir à mieux faire comprendre la présente invention, mais aussi contribuer à sa définition, le cas échéant.

La présente description est de nature à faire intervenir des éléments susceptibles de protection par le droit d'auteur et/ou le copyright. Le titulaire des droits n'a pas d'objection à la reproduction à l'identique par quiconque du présent document de brevet ou de sa description, telle qu'elle apparaît dans les dossiers officiels. Pour le reste, il réserve intégralement ses droits.

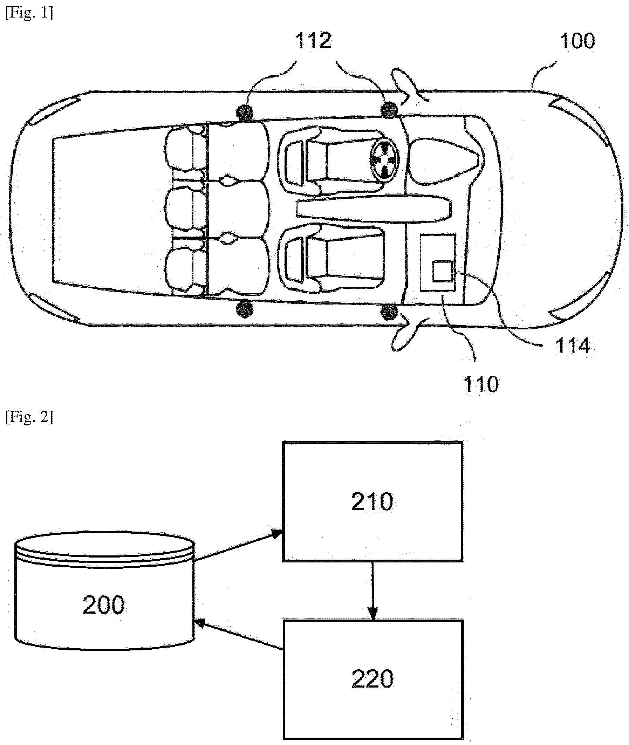

La [Fig.1] représente un système de diffusion 110 d'un signal audio implémenté mettant en œuvre l'invention dans un environnement de diffusion qui prend la forme d'un véhicule 100. Le véhicule est ici représenté sous la forme d'une voiture, mais l'invention s'applique à tout type de véhicule. Comme cela apparaîtra plus bas, l'invention repose particulièrement sur le fait que le véhicule 100 met en œuvre un bus de communication de données comme un bus CAN.

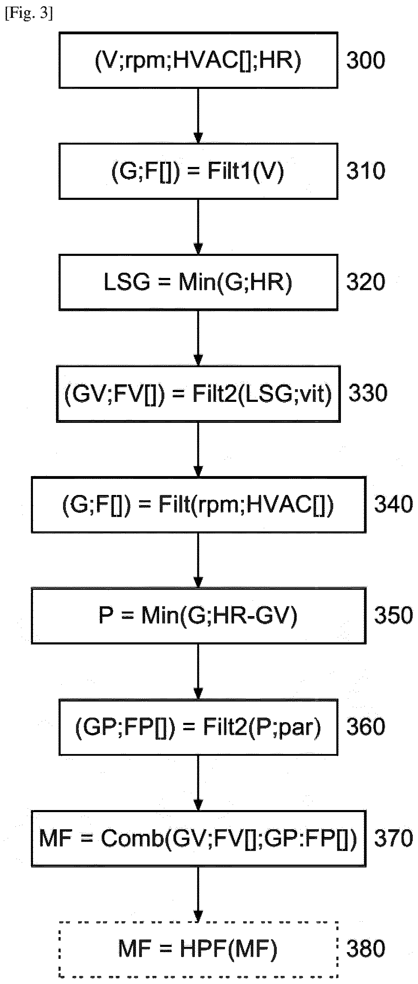

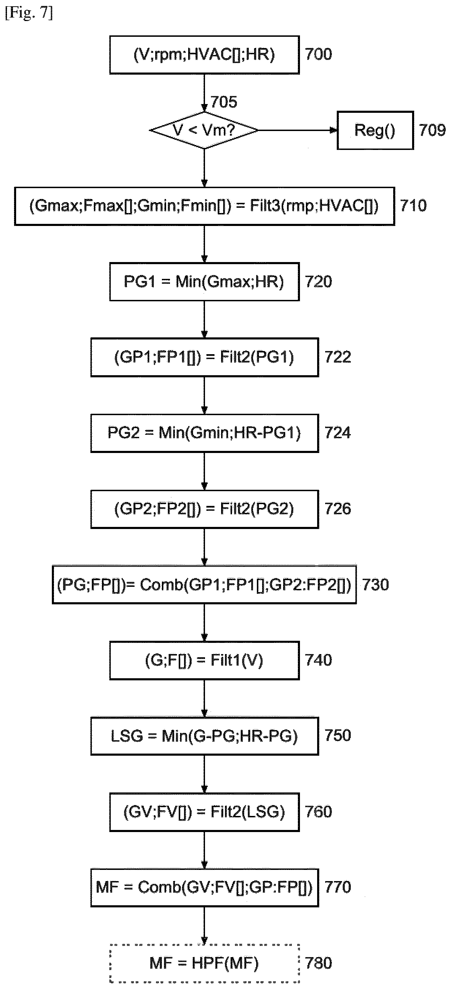

Le système de diffusion 110 comprend plusieurs haut-parleurs 112 ainsi qu'un dispositif d'égalisation 114 selon l'invention. Le dispositif d'égalisation 114 est configuré pour mettre en œuvre une égalisation par masquage selon l'un quelconque des modes de réalisation décrit avec la [Fig.3] ou la [Fig.7]. La [Fig.2] représente un exemple schématique de la mise en œuvre du dispositif 114.

Dans divers modes de réalisation, le dispositif d'égalisation 114 n'est pas intégré au système de diffusion 110, mais connecté à celui-ci via une liaison filaire (par exemple une liaison USB ou équivalente) ou sans-fil (par exemple une liaison Bluetooth, WiFi ou équivalente) afin d'échanger les données, comme le signal audio diffusé et le signal audio égalisé. Le système de diffusion 110 peut comprendre un unique haut-parleur 112.

La [Fig.2] représente un exemple schématique de mise en œuvre du dispositif d'égalisation 114. Dans l'exemple décrit ici, le dispositif d'égalisation 114 comprend une mémoire 200, un collecteur 210 et un calculateur 220.

La mémoire 200 peut être tout type de stockage de données propre à recevoir des données numériques : disque dur, disque dur à mémoire flash, mémoire flash sous toute forme, mémoire vive, disque magnétique, stockage distribué localement ou dans le cloud, etc. Néanmoins, compte tenu de l'application automobile de l'invention, la mémoire 200 sera plus probablement une mémoire flash ou un disque dur auquel peuvent accéder le système 110, le collecteur 210 et le calculateur 220.

Dans l'exemple décrit ici, la mémoire 200 reçoit toutes les données qui concernent le dispositif 114, c'est-à-dire les programmes et logiciels instanciant le collecteur 210 et le calculateur 220, leurs paramètres, les données reçues en entrée (le cas échéant), les valeurs de gain et de coefficient de filtre intermédiaires, les données stockées en mémoire tampon, ainsi que les données de filtre de masquage en sortie. Les données calculées par le dispositif peuvent être stockées sur tout type de mémoire similaire à la mémoire 200, ou sur celle-ci. Ces données peuvent être effacées après que le dispositif a effectué ses tâches ou conservées.

La mémoire 200 reçoit des jeux de données de filtre de vitesse comprenant des triplets associant une valeur de vitesse, une valeur de gain, et des coefficients de filtre de masquage de vitesse, et des jeux de données de filtre fonctionnel comprenant des triplets associant une valeur de régime moteur ou une valeur de ventilation, une valeur de gain, et des coefficients de filtre de masquage de moteur ou de ventilation. Les jeux de coefficient permettent d'implémenter rapidement et à coût faible les divers filtres. Les jeux de coefficients pourront être génériques ou être spécifiquement adaptés à chaque véhicule. Dans le cadre de l'invention, cette dernière option est préférée. Dans les exemples décrits ici, les filtres de masquage mis en œuvre sont des filtres biquadratiques. En variante, ces filtres pourraient être d'autre type comme des filtres récursifs ou des filtres à réponse impulsionnelle finie réalisés dans le domaine temporel. Ces filtres peuvent être aussi réalisés dans le domaine fréquentiel.

La mémoire 200 reçoit comme données d'entrée des paramètres, ainsi qu'une ou plusieurs données de marge sonore.

Les paramètres servent à définir les caractéristiques des phénomènes de bruit de masquage que le dispositif 114 vise à filtrer. Ces paramètres sont obtenus par le collecteur 210 à partir d'un bus de communication du véhicule, par exemple le bus CAN. Cette mise en œuvre est particulièrement avantageuse car le bus CAN fait circuler de nombreuses informations qui permettent de qualifier l'état du véhicule, que ce soit sa vitesse, son régime moteur ou d'autres informations fonctionnelles comme les paramètres du système HVAC (par exemple et de manière non limitative, un indicateur de fonctionnement, une valeur de vitesse de ventilation et une valeur de puissance de ventilation. Dans ce qui suit, la vitesse représente un paramètre de vitesse, tandis que le régime moteur et les paramètres du système HVAC représentent un paramètre fonctionnel. La raison de cette distinction est que la vitesse représente une source de bruit assez connue, tant par le revêtement que l'aérodynamique et le roulement du véhicule, et le filtrage du masquage qui lui est associé est assez connu. En revanche, le filtrage du masquage des bruits liés au moteur ou au système HVAC est mal maîtrisé dès lors que l'on souhaite le calculer avec un coût raisonnable. C'est pour cela que la méthode SDEC par exemple ne les traites pas.

La Demanderesse s'est rendu compte avec surprise que, contre toute attente, le CAN fournit toutes les données essentielles pour définir des bruits fonctionnels comme le bruit moteur ou le bruit HVAC, ce qui rend possible de compléter le filtrage SDEC. Comme on le verra plus bas, cette distinction entre diverses sources et leur caractérisation permet un traitement différencié qui approche la performance du NDEC, mais avec un coût bien moindre et une très grande polyvalence de plateformes de véhicules, sans qu'un micro ne soit nécessaire. Cette simplicité qui s'appuie sur le CAN préexistant (ou un autre bus de communication) permet par ailleurs de simplifier l'intégration du dispositif 114 dans le véhicule.

Ainsi, pour gagner en coûts de calcul, les plages de vitesse, de régime moteur et de données de système HVAC sont discrétisées pour associer à chacune un gain de filtre et des coefficients de filtre stockés dans la mémoire 200. Ainsi, chaque triplet associant une valeur de vitesse (respectivement de régime moteur ou de données de système HVAC), un gain et un jeu de coefficients de filtre définit un jeu de données de filtre de vitesse (respectivement de moteur ou de ventilation). Ces jeux de données de filtre sont manipulés par le calculateur 220 pour calculer le filtre d'égalisation de masquage. De manière préférée, les jeux de données de filtre sont personnalisés pour chaque famille de véhicule et font l'objet d'un réglage préalable à la mise en œuvre du dispositif 114.

Les données de marge sonore peuvent être de deux natures : l'atténuation d'une part, liée au volume sonore voulu pour le signal audio, et un maximum de gain souhaité pour le dispositif 114. Dans ce qui suit, la marge sonore représentera la plus petite de ces deux valeurs. En variante, une seule de ces deux valeurs peut être considérée, auquel cas la marge sonore est soit égale à l'atténuation, soit égale au maximum de gain souhaité, selon le cas prévu.

Le collecteur 210 et le calculateur 220 accèdent directement ou indirectement à la mémoire 200. Ils peuvent être réalisés sous la forme d'un code informatique approprié exécuté sur un ou plusieurs processeurs. Par processeurs, il doit être compris tout processeur adapté aux calculs décrits plus bas. Un tel processeur peut être réalisé de toute manière connue, sous la forme d'un microprocesseur pour ordinateur personnel, portable, tablette ou smartphone, d'une puce dédiée de type FPGA ou SoC, d'une ressource de calcul sur une grille ou dans le cloud, d'une grappe de processeurs graphiques (GPUs), d'un microcontrôleur, ou de toute autre forme propre à fournir la puissance de calcul nécessaire à la réalisation décrite plus bas. Un ou plusieurs de ces éléments peuvent également être réalisés sous la forme de circuits électroniques spécialisés tel un ASIC. Une combinaison de processeur et de circuits électroniques peut également être envisagée. Compte tenu du contexte automobile de l'invention, les processeurs les plus simples possibles seront préférés afin d'optimiser le coût du dispositif 114.

Il apparaîtra par ailleurs que le collecteur 210 a pour seule fonction la récupération des paramètres et de la marge sonore pour faire fonctionner le calculateur 220. En variante, le collecteur 210 et le calculateur 220 pourraient être fusionnés, ou au contraire le calculateur 220 pourrait être éclaté en unité plus petites, dès lors que fonctionnellement le fonctionnement du dispositif 114 ne change pas.

La [Fig.3] représente un premier mode de réalisation d'égalisation de masquage mise en œuvre par le dispositif de la [Fig.2]. Dans ce mode de réalisation, il est considéré que la vitesse est la source de bruit la plus importante. Pour cette raison, son traitement est priorisé. Ensuite, le bruit associé au paramètre fonctionnel est traité, et ce traitement dépend comme on le verra du traitement du bruit de vitesse. Dans l'exemple représenté sur la [Fig.3], un seul paramètre fonctionnel est considéré comme présent. En variante, il serait possible de traiter plusieurs paramètres fonctionnels, par exemple à la manière de ce qui est décrit avec le deuxième mode de réalisation d'égalisation de masquage.

Dans une opération 300, le collecteur 210 récupère du bus CAN les données nécessaires au traitement par le calculateur 220, c'est-à-dire la vitesse du véhicule V (paramètre de vitesse), un parmi le régime moteur rpm et les données de ventilation HVAC[]), et la marge sonore HR. La vitesse V, le régime moteur rpm et les données de ventilations HVAC[] pourront être obtenus par toute donnée circulant sur le CAN (ou autre bus de communication du véhicule), de manière directe ou indirecte.

Ensuite le bruit de vitesse est traité dans des opérations 310, 320 et 330. Dans l'opération 310, le calculateur 220 appelle la mémoire 200 afin de récupérer le jeu de données de filtre de vitesse qui correspond à la vitesse V au moyen d'une fonction Filt1() qui reçoit la vitesse V comme argument. Si la valeur de la vitesse V n'est pas présente dans les jeux de données de filtre de vitesse présents dans la mémoire 200, la fonction Filt1() peut retourner le jeu de données de filtre de vitesse dont la vitesse est la plus proche de la vitesse V ou un jeu de données de filtre de vitesse tiré d'une interpolation d'un ou plusieurs jeux de données de filtre de vitesse. Ensuite, dans l'opération 320, un gain LSG est déterminé au moyen d'une fonction Min(). La fonction Min() a pour rôle de tenir compte dans le traitement par le calculateur 220 du fait que la marge sonore (ou *"headroom"* en anglais) est finie : il n'est pas possible d'appliquer n'importe quelle correction au signal audio en fonction de son volume. De plus, si le signal audio joué est très fort, au-delà des risques de saturation des haut-parleurs 112, il peut être considéré comme inutile d'amplifier le signal pour filtrer le masquage. Ainsi, dans l'exemple décrit ici, la fonction Min() retient la valeur la plus faible entre la valeur de gain du jeu de données de filtre de vitesse de l'opération 310 et la marge sonore. Enfin, dans l'opération 330, si l'opération 320 a généré un gain LSG différent du gain de l'opération 310, une fonction Filt2() est exécutée dans l'opération 330 pour déterminer le jeu de données de filtre de vitesse dans la mémoire 200 dont le gain correspond le mieux au gain LSG. Là encore, la fonction Filt2() peut retourner le jeu de données de filtre de vitesse dont le gain GV est le plus proche du gain LSG, ou un jeu de données de filtre de vitesse tiré d'une interpolation d'un ou plusieurs jeux de données de filtre de vitesse.

Après les opérations 310 à 330, le calculateur 220 exécute des opérations 340 à 360 pour traiter le bruit associé au paramètre fonctionnel. Comme mentionné plus haut, le mode de réalisation de la [Fig.3] ne traite qu'un unique paramètre fonctionnel, que ce soit le régime moteur ou des données de ventilation. L'opération 340 est similaire à l'opération 310 et exécute la fonction Filt1() avec le paramètre fonctionnel considéré pour déterminer le jeu de données de filtre fonctionnel qui s'en approche le plus dans la mémoire 200. Ensuite, dans l'opération 350, un gain P est calculé pour tenir compte de la marge sonore, de manière similaire à l'opération 320. Cependant, pour tenir compte du traitement des opérations 310 à 340, ce n'est pas la marge sonore qui est comparée au gain du jeu de données de filtre fonctionnel de l'opération 340, mais la marge sonore amputée du gain de vitesse GV de l'opération 330. Enfin, dans l'opération 360, le jeu de données de filtre fonctionnel de l'opération 340 est retraité en fonction du gain fonctionnel P déterminé à l'opération 350, et le jeu de données de filtre fonctionnel FP[] est retourné.

Enfin, dans une opération 370, le calculateur 220 exécute une fonction Comb() qui combine le gain de vitesse GV et le jeu de données de filtre de vitesse FV[] de l'opération 330 avec gain fonctionnel GP et le jeu de données de filtre fonctionnel FP[] de l'opération 360 pour calculer le filtre d'égalisation de masquage MF.

Dans un mode de réalisation préféré, le filtre d'égalisation de masquage MF est raffiné dans une opération 380 optionnelle au moyen d'un filtre passe-haut afin de protéger les haut-parleurs 112 contre un gain excessif dans les basses.

Il apparaît que les opérations 310 et 340 peuvent être réalisées en parallèles. Les opérations 350 suivantes dépendent en revanche des opérations 320 et 330.

Il apparaît donc que, par touche successive, le filtre d'égalisation de masquage est construit en tenant compte de la marge sonore disponible. Afin d'abaisser encore les coûts de l'invention, les calculs des coefficients des filtres peuvent être réalisés en stockant des jeux de données de filtre de type passe-tout ("*Allpass*" en anglais) qui sont modifiés en fonction du gain déterminé à certaines étapes. Par exemple le jeu de données de filtre de l'opération 360 peut être déterminé à partir des opérations suivantes :

- gainLin = Transformation de la valeur de gain fonctionnel (en dB) en gain linéaire selon la formule gainLin=$10^{\wedge}(P/20)$ ;

$$b0 = 0.5 * ((1 + gainLin) + b0\_ap * (1 - gainLin)) ;$$

$$b1 = 0.5 * ((1 + gainLin) * a1\_ap + b1\_ap * (1 - gainLin)) ;$$

$$b2 = 0.5 * ((1 + gainLin) * a2\_ap + (1 - gainLin)) ;$$

$$a1 = a1\_ap ;$$

et

$$a2 = a2\_ap.$$

où les ai et bi sont les coefficient du jeu de données de filtre fonctionnel FP[] et les ai_ap et bi_ap sont les coefficient du jeu de données de filtre passe tout.

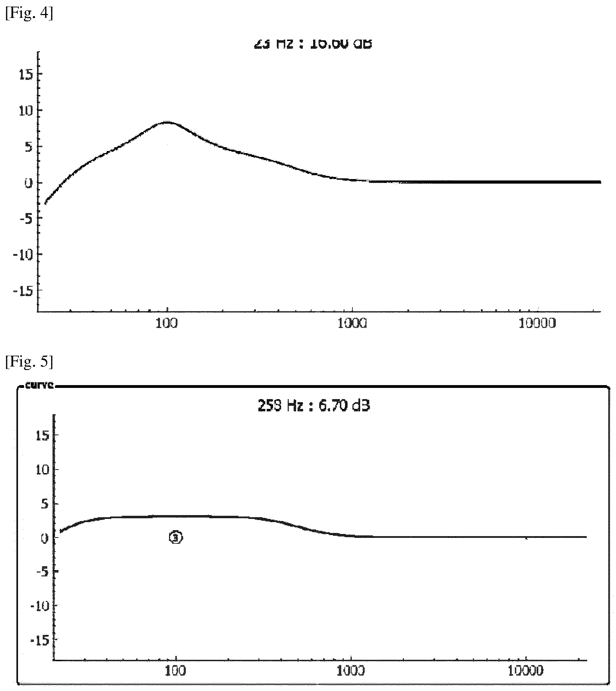

La [Fig.4] représente un exemple de filtre d'égalisation de masquage produit lorsque la marge sonore est plus importante que la somme du gain de vitesse et du gain fonctionnel.

Cet exemple est basé sur les données suivantes : une vitesse de 70km/h correspondant à un jeu de données de filtre de vitesse présentant un gain de 3,3dB, une marge sonore de 13dB, et une valeur de fréquence fondamentale de bruit de moteur de 120Hz déterminée à partir de la valeur rpm de 3600 comme le produit du régime moteur (rpm) par le nombre de cylindres divisé par 120 (d'autres formules pourraient être retenues) correspondant à un jeu de données de filtre de vitesse présentant un gain de 5dB.

La fonction Min() de l'opération 320 retourne un gain de vitesse de 3,3dB, ce qui signifie que le jeu de données de filtre de vitesse de l'opération 310 est inchangé. Ensuite, le gain fonctionnel est déterminé en comparant le gain de 5dB à la valeur 13-3,3 soit 9,7dB, ce qui signifie que, là encore, le jeu de données de filtre fonctionnel de l'opération 340 est inchangé. Par la nature du bruit de moteur, les coefficients du jeu de données de filtre de moteur seront reliés aux harmoniques de la fréquence fondamentale du bruit moteur qui est la fréquence de 120Hz explicitée plus haut.

Enfin, le gain final est calculé en retranchant le gain de vitesse et le gain fonctionnel à la marge sonore, soit 13-3,3-5=4,7dB qui est utilisée comme valeur de référence par le filtre passe haut de l'opération 380.

La [Fig.5] représente un exemple de filtre d'égalisation de masquage produit lorsque la marge sonore est plus faible que le gain du jeu de données de filtre de vitesse associé à la vitesse du véhicule.

Cet exemple est basé sur les données suivantes : une vitesse de 105km/h correspondant à un jeu de données de filtre de vitesse présentant un gain de 4dB, une marge sonore de 3,1dB, et une valeur de la fréquence fondamentale du bruit du moteur de 120Hz correspondant à un jeu de données de filtre de vitesse présentant un gain de 5dB.

La fonction Min() de l'opération 320 retourne un gain de vitesse de 3,1dB, ce qui signifie que le jeu de données de filtre de vitesse de l'opération 310 doit être modifié dans l'opération 330. Hélas, l'opération 330 retourne un jeu de données de filtre de vitesse dont le gain de vitesse est 3,1dB. Dès lors, le gain fonctionnel n'a pas à être calculé car l'opération 350 retournera forcément 0dB (3,1-3,1). Il en est de même pour le filtre passe haut. Dans ce cas, il n'y a pas de filtre fonctionnel appliqué (c'est le filtre d'ordre 0 qui est appliqué).

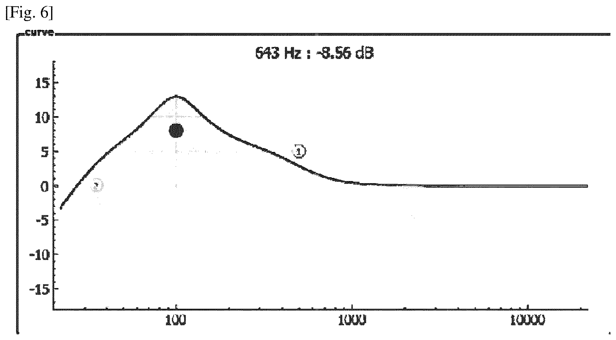

La [Fig.6] représente un troisième exemple qui concerne le cas où la marge sonore est plus importante que le gain du jeu de données de filtre de vitesse associé à la vitesse du véhicule, mais moins importante que le gain de vitesse ajouté du gain du jeu de données de filtre fonctionnel associé au paramètre fonctionnel.

Cet exemple est basé sur les données suivantes : une vitesse de 105km/h correspondant à un jeu de données de filtre de vitesse présentant un gain de 4dB, une marge sonore de 3dB, et une valeur de la fréquence fondamentale du bruit du moteur de 120Hz correspondant à un jeu de données de filtre de vitesse présentant un gain de 5dB.

La fonction Min() de l'opération 320 retourne un gain de vitesse de 3dB, ce qui signifie que le jeu de données de filtre de vitesse de l'opération 310 doit être modifié dans l'opération 330. Dans cet exemple, l'opération 330 retourne un jeu de données de filtre de vitesse dont le gain de vitesse est 2dB. Dès lors, le gain fonctionnel va être calculé comme suit : Min(5;3-2)=1dB. Le filtre fonctionnel est déterminé en conséquence dans l'opération 360, et le filtre passe haut d'ordre 0 est appliqué car la marge sonore de 3dB est égale à la somme du gain de vitesse (2dB) et du gain fonctionnel (1dB).

Ces exemples sont arbitraires mais permettent de voir comment la prise en compte de la marge sonore vient significativement modifier la définition du filtre d'égalisation de masquage.

La [Fig.7] représente un mode de réalisation en variante qui tient compte d'une subtilité et explicite le traitement du cas où un paramètre fonctionnel de vitesse et un paramètre fonctionnel de données de ventilation sont présents.

Dans ce mode de réalisation, les opérations similaires à celles de la [Fig.3] présentent des références numériques dont les deux derniers chiffres sont identiques à ceux des opérations de la [Fig.3]. Seules les différences seront décrites.

La principale différence de ce mode de réalisation est qu'il tient compte d'un seuil de vitesse pour hiérarchiser le traitement du bruit de vitesse par rapport au bruit fonctionnel. Comme l'a fait apparaître la [Fig.3], à partir de la marge sonore, chaque traitement vient entamer la marge restante pour traiter le bruit restant.

Lorsque la vitesse est élevée, le bruit aérodynamique est très important et doit être priorisé par rapport au bruit fonctionnel. Par contre, à faible vitesse, par exemple en dessous de 50km/h, il peut être intéressant d'inverser le traitement.

Ainsi, dans une opération 705, la vitesse V est comparée à un seuil Vm. Si cette comparaison indique une vitesse élevée, alors le traitement décrit avec la [Fig.3] est exécuté (avec l'ajout du traitement des deux paramètres fonctionnels décrit ci-après)) dans une opération 709.

Dans le cas contraire, le bruit fonctionnel va être traité en priorité. Dans le mode de réalisation décrit ici, deux bruits fonctionnels distincts sont traités : le bruit de moteur et le bruit de ventilation. Pour savoir lequel traiter en priorité, une fonction Filt3() est exécutée dans une opération 710 similaire à l'opération 310 pour récupérer le jeu de données de filtre moteur correspondant au paramètre fonctionnel rpm et le jeu de données de filtre de ventilation correspondant au paramètre fonctionnel de données de ventilation HVAC[]. Ces deux jeux sont classés en fonction du gain qui leur est associé, et dans une opération 720 et une opération 722, un premier gain fonctionnel PG1 et son jeu de coefficients est déterminé similairement à l'opération 320, et un deuxième gain fonctionnel PG2 et son jeu de coefficients est déterminé en tenant compte du premier gain fonctionnel PG1 dans des opérations 724 et 726. Enfin, dans une opération 730, les coefficients de gain fonctionnel PG1 et PG2 et leurs jeux de coefficients correspondants sont combinés dans une opération 730. Ainsi, il apparaît que le traitement hiérarchique par érosion de la marge sonore est répliqué sur les paramètres fonctionnels de nature distincte.

Ensuite, dans des opérations 740, 750 et 760, le gain de vitesse et le jeu de données de filtre de vitesse sont déterminés similairement aux opérations 340 à 360 (au détail près que le "fonctionnel" et la "vitesse" ont des rôles inversés), puis le filtre d'égalisation de masquage est calculé dans une opération 770 et une opération 780 optionnelle applique le filtre passe haut.

Dans ce qui précède, les jeux de données de filtre sont formés par des triplets qui associent une valeur d'index (la vitesse, le régime moteur ou les données de ventilation) et une valeur de gain associée à des coefficients qui définissent ensemble un filtre de masquage. Cependant, le couple valeur de gain / coefficients pourrait être représenté par des coefficients seuls, la valeur de gain étant implicitement contenu dans la norme des coefficients.

Au vu de ce qui précède, la Demanderesse a donc développé un traitement qui permet de tenir compte de divers types de bruits, de récupérer les informations les concernant dans une source directe disponible (le bus de communication) et de calculer un filtre d'égalisation de masquage avec un coût de calcul très faible. Cela était imprévisible en partant du SDEC, comme en témoigne la demande de brevet NDEC déposée par la Demanderesse sous le numéro FR2211921.

**Revendications**

1. Dispositif d'égalisation de signal audio pour véhicule mettant en œuvre un bus de communication de données comprenant :

   - une mémoire (200) agencée pour stocker des jeux de données de filtre de vitesse comprenant des triplets associant une valeur de vitesse du véhicule (V) et une valeur de gain associée à des coefficients pour définir un filtre de masquage de vitesse, et des jeux de données de filtre fonctionnel comprenant des triplets associant une valeur de régime moteur (rpm) ou une valeur de ventilation (HVAC[]) et une valeur de gain associée à des coefficients pour définir un filtre de masquage de moteur ou de ventilation,
   - un collecteur (210) agencé pour recevoir au moins deux paramètres accessibles sur le bus de communication, lesquels paramètres désignent la vitesse du véhicule (V) et au moins un paramètre fonctionnel choisi dans le groupe comprenant le régime moteur du véhicule (rpm) et un jeu de données de ventilatior (HVAC[]), et
   - un calculateur (220) agencé pour recevoir en entrée une valeur de marge sonore (HR), ainsi que lesdits au moins deux paramètres accessibles sur le bus de communication, pour en tirer au moins un jeu de données de filtre de vitesse (FV[]) et au moins un jeu de données de filtre fonctionnel (FP[]) et pour les combiner en un filtre d'égalisation de masquage (MF) à appliquer à un signal audio.

2. Dispositif selon la revendication 1, dans lequel le calculateur (220) est agencé :

   - pour déterminer le jeu de données de filtre de vitesse et le jeu de données de filtre fonctionnel dans la mémoire (200) à partir des au moins deux paramètres déterminés par le collecteur (210),
   - pour calculer une valeur de gain de vitesse (GV) à partir d'au moins la valeur de gain du jeu de données de filtre de vitesse déterminé et de la valeur de marge sonore et pour en tirer le jeu de données de filtre de vitesse, et
   - pour déterminer une valeur de gain fonctionnel (GP) à partir d'au moins la valeur de gain du jeu de données de filtre fonctionnel déterminé, de la valeur de gain de vitesse et de la valeur de marge sonore et pour en tirer le jeu de données de filtre fonctionnel.

3. Dispositif selon la revendication 2, dans lequel le calculateur (220) est agencé pour calculer la valeur de gain de vitesse à partir du minimum entre la valeur de gain du jeu de données de filtre de vitesse déterminé et la valeur de marge sonore, et pour calculer la valeur de gain fonctionnel à partir du minimum entre la valeur de gain du jeu de données de filtre fonctionnel déterminé et la différence entre la valeur de marge sonore et la valeur de gain de vitesse.

4. Dispositif selon la revendication 2 ou 3, dans lequel le calculateur (220) est agencé, en présence d'un paramètre fonctionnel de régime moteur et d'un paramètre fonctionnel de jeu de données de ventilation :

   - pour déterminer un jeu de données de filtre fonctionnel principal et un deuxième jeu de données de filtre fonctionnel secondaire à partir du paramètre fonctionnel de régime moteur et du paramètre fonctionnel de jeu de données de ventilation, la valeur de gain du jeu de données de filtre fonctionnel principal étant supérieure à la valeur de gain du jeu de données de filtre fonctionnel secondaire,
   - pour déterminer une première valeur de gain fonctionnel à partir d'au moins la valeur de gain du jeu de données de filtre fonctionnel principal, de la valeur de gain de vitesse et de la valeur de marge sonore et en tirer un premier jeu de données de filtre fonctionnel,
   - pour déterminer une deuxième valeur de gain fonctionnel à partir d'au moins la valeur de gain du jeu de données de filtre fonctionnel secondaire, de la première valeur de gain fonctionnel, de la valeur de gain de vitesse et de la valeur de marge sonore et en tirer un deuxième jeu de données de filtre fonctionnel, et
   - pour calculer une valeur de gain fonctionnel et le jeu de données de filtre fonctionnel à partir de la première valeur de gain fonctionnel, de la deuxième valeur de gain fonctionnel, du premier jeu de données de filtre fonctionnel et du deuxième jeu de données de filtre fonctionnel.

5. Dispositif selon la revendication 1, dans lequel, le calculateur (220) est agencé, lorsque le paramètre de vitesse est inférieur à un seuil choisi :

   - pour déterminer le jeu de données de filtre fonctionnel et le jeu de données de filtre de vitesse dans la mémoire (200) à partir des au moins deux paramètres déterminés par le collecteur (210),
   - pour déterminer une valeur de gain fonctionnel à partir d'au moins la valeur de gain du jeu de données de filtre fonctionnel déterminé et de la valeur de marge sonore et pour en tirer le jeu de données de filtre fonctionnel à partir de la valeur de gain fonctionnel, et

- pour déterminer une valeur de gain de vitesse à partir d'au moins la valeur de gain du jeu de données de filtre de vitesse déterminé, de la valeur de gain fonctionnel et de la valeur de marge sonore et pour en tirer le jeu de données de filtre de vitesse à partir du gain de vitesse.

6. Dispositif selon la revendication 5, dans lequel le calculateur (220) est agencé pour calculer la valeur de gain fonctionnel en retenant le minimum entre la valeur de gain du jeu de données de filtre fonctionnel déterminé et la valeur de marge sonore, et pour calculer la valeur de gain de vitesse en retenant le minimum entre la valeur de gain du jeu de données de filtre de vitesse déterminé et la différence entre la valeur de marge sonore et la valeur de gain fonctionnel.

7. Dispositif selon la revendication 5 ou 6, dans lequel le calculateur (220) est agencé, en présence d'un paramètre fonctionnel de régime moteur et d'un paramètre fonctionnel de jeu de données de ventilation :

   - pour déterminer un jeu de données de filtre fonctionnel principal et un jeu de données de filtre fonctionnel secondaire à partir du paramètre fonctionnel de régime moteur et du paramètre fonctionnel de jeu de données de ventilation, la valeur de gain du jeu de données de filtre fonctionnel principal étant supérieure à la valeur de gain du jeu de données de filtre fonctionnel secondaire,
   - pour déterminer une première valeur de gain fonctionnel à partir d'au moins la valeur de gain du jeu de données de filtre fonctionnel principal et de la valeur de marge sonore et en tirer un premier jeu de données de filtre fonctionnel,
   - pour déterminer une deuxième valeur de gain fonctionnel à partir d'au moins la valeur de gain du jeu de données de filtre fonctionnel secondaire, de la première valeur de gain fonctionnel et de la valeur de marge sonore et en tirer un deuxième jeu de données de filtre fonctionnel, et
   - pour calculer une valeur de gain fonctionnel et le jeu de données de filtre fonctionnel à partir de la première valeur de gain fonctionnel, de la deuxième valeur de gain fonctionnel, du premier jeu de données de filtre fonctionnel et du deuxième jeu de données de filtre fonctionnel.

8. Dispositif selon l'une des revendications précédentes, dans lequel le calculateur (220) est agencé pour appliquer un filtre passe-haut au filtre d'égalisation de masquage en fonction de la différence entre la marge sonore, la valeur de gain de vitesse et la valeur de gain fonctionnel.

9. Procédé d'égalisation de signal audio pour véhicule mettant en œuvre un bus de communication de données comprenant :

   a) stocker des jeux de données de filtre de vitesse comprenant des triplets associant une valeur de vitesse du véhicule et une valeur de gain associée à des coefficients pour définir un filtre de masquage de vitesse, et des jeux de données de filtre fonctionnel comprenant des triplets associant une valeur de régime moteur ou une valeur de ventilation et une valeur de gain associée à des coefficients pour définir un filtre de masquage de moteur ou de ventilation,
   b) recevoir au moins deux paramètres accessibles sur le bus de communication de données, lesquels paramètres désignent la vitesse du véhicule et au moins un paramètre fonctionnel choisi dans le groupe comprenant le régime moteur du véhicule et un jeu de données de ventilation, et une valeur de marge sonore, et
   c) tirer des paramètres de l'étape b) et de la valeur de marge sonore au moins un jeu de données de filtre de vitesse et au moins un jeu de données de filtre fonctionnel et pour les combiner en un filtre d'égalisation de masquage à appliquer à un signal audio.

10. Procédé d'égalisation de signal audio selon la revendication 9, dans lequel l'opération c) comprend

   c1) déterminer le jeu de données de filtre de vitesse et le jeu de données de filtre fonctionnel à partir des au moins deux paramètres déterminés par le collecteur (210),
   c2) calculer une valeur de gain de vitesse à partir d'au moins la valeur de gain du jeu de données de filtre de vitesse déterminé et de la valeur de marge sonore et en tirer le jeu de données de filtre de vitesse, et
   c3) déterminer une valeur de gain fonctionnel à partir d'au moins la valeur de gain du jeu de données de filtre fonctionnel déterminé, de la valeur de gain de vitesse et de la valeur de marge sonore et en tirer le jeu de données de filtre fonctionnel.

11. Procédé d'égalisation de signal audio selon la revendication 10, dans lequel l'opération c2) comprend calculer la valeur de gain de vitesse à partir du minimum entre la valeur de gain du jeu de données de filtre de vitesse déterminé, la valeur de marge sonore, et l'opération c3) comprend calculer la valeur de gain fonctionnel à partir du minimum entre la valeur de gain du jeu de données de filtre fonctionnel déterminé, la différence entre la valeur de marge sonore et la valeur de gain de vitesse.

12. Procédé d'égalisation de signal audio selon la revendication 10 ou 11, dans lequel lorsque l'opération b) retourne un paramètre fonctionnel de régime moteur et un paramètre fonctionnel de jeu de données de ventilation, l'opération c3) comprend :

c3a) déterminer un jeu de données de filtre fonctionnel principal et un deuxième jeu de données de filtre fonctionnel secondaire à partir du paramètre fonctionnel de régime moteur et du paramètre fonctionnel de jeu de données de ventilation, la valeur de gain du jeu de données de filtre fonctionnel principal étant supérieure à la valeur de gain du jeu de données de filtre fonctionnel secondaire,
c3b) déterminer une première valeur de gain fonctionnel à partir d'au moins la valeur de gain du jeu de données de filtre fonctionnel principal, de la valeur de gain de vitesse et de la valeur de marge sonore et en tirer un premier jeu de données de filtre fonctionnel,
c3c) déterminer une deuxième valeur de gain fonctionnel à partir d'au moins la valeur de gain du jeu de données de filtre fonctionnel secondaire, de la première valeur de gain fonctionnel, de la valeur de gain de vitesse et de la valeur de marge sonore et en tirer un deuxième jeu de données de filtre fonctionnel, et
c3d) calculer une valeur de gain fonctionnel et le jeu de données de filtre fonctionnel à partir de la première valeur de gain fonctionnel, de la deuxième valeur de gain fonctionnel, du premier jeu de données de filtre fonctionnel et du deuxième jeu de données de filtre fonctionnel.

13. Procédé d'égalisation de signal audio selon la revendication 9, dans lequel, lorsque le paramètre de vitesse de l'opération b) est inférieur à un seuil choisi, l'opération c) comprend :

c1) déterminer le jeu de données de filtre fonctionnel et le jeu de données de filtre de vitesse dans la mémoire (200) à partir des au moins deux paramètres déterminés par le collecteur (210),
c2) déterminer une valeur de gain fonctionnel à partir d'au moins la valeur de gain du jeu de données de filtre fonctionnel déterminé et de la valeur de marge sonore et en tirer un jeu de données de filtre fonctionnel à partir de la valeur de gain fonctionnel, et
c3) déterminer une valeur de gain de vitesse à partir d'au moins la valeur de gain du jeu de données de filtre de vitesse déterminé, de la valeur de gain fonctionnel et de la valeur de marge sonore et en tirer le jeu de données de filtre de vitesse à partir du gain de vitesse.

14. Procédé d'égalisation de signal audio selon la revendication 13, dans lequel l'opération c1) comprend calculer la valeur de gain fonctionnel en retenant le minimum entre la valeur de gain du jeu de données de filtre fonctionnel déterminé, la valeur de marge sonore, et l'opération c2) comprend calculer la valeur de gain de vitesse en retenant le minimum entre la valeur de gain du jeu de données de filtre de vitesse déterminé, la différence entre la valeur de marge sonore et la valeur de gain fonctionnel.

15. Procédé d'égalisation de signal audio selon la revendication 13 ou 14, dans lequel lorsque l'opération b) retourne un paramètre fonctionnel de régime moteur et un paramètre fonctionnel de jeu de données de ventilation, l'opération c2) comprend :

c2a) déterminer un jeu de données de filtre fonctionnel principal et un jeu de données de filtre fonctionnel secondaire à partir du paramètre fonctionnel de régime moteur et du paramètre fonctionnel de jeu de données de ventilation, la valeur de gain du jeu de données de filtre fonctionnel principal étant supérieure à la valeur de gain du jeu de données de filtre fonctionnel secondaire,
c2b) déterminer une première valeur de gain fonctionnel à partir d'au moins la valeur de gain du jeu de données de filtre fonctionnel principal et de la valeur de marge sonore et en tirer un premier jeu de données de filtre fonctionnel,
c2c) déterminer une deuxième valeur de gain fonctionnel à partir d'au moins la valeur de gain du jeu de données de filtre fonctionnel secondaire, de la première valeur de gain fonctionnel et de la valeur de marge sonore et en tirer un deuxième jeu de données de filtre fonctionnel, et
c2d) calculer une valeur de gain fonctionnel et le jeu de données de filtre fonctionnel à partir de la première valeur de gain fonctionnel, de la deuxième valeur de gain fonctionnel, du premier jeu de données de filtre fonctionnel et du deuxième jeu de données de filtre fonctionnel.

16. Procédé d'égalisation de signal audio selon l'une des revendications 9 à 15, comprenant en outre l'opération d) appliquer un filtre passe-haut au filtre d'égalisation de masquage en fonction de la différence entre la marge sonore, la valeur de gain de vitesse et la valeur de gain fonctionnel.

17. Programme informatique mis en œuvre par ordinateur comprenant des instructions pour exécuter le procédé selon l'une des revendications 9 à 16.

18. Support de stockage de données sur lequel est enregistré le programme informatique selon la revendication 17.

**Patentansprüche**

1. Audiosignal-Entzerrungsvorrichtung für Fahrzeuge, die einen Datenkommunikationsbus einsetzt und Folgendes umfasst:

   - einen Speicher (200), der so angeordnet ist, dass er Geschwindigkeitsfilter-Datensätze, die Tripletts umfassen, die einen Geschwindigkeitswert und einen Verstärkungswert zuordnen, der Koeffizienten zugeordnet ist, um einen Geschwindigkeitsmaskierungsfilter zu definieren, und Funktionsfilter-Datensätze speichert, die Tripletts umfassen, die einen Motordrehzahlwert oder einen Belüftungswert und einen Verstärkungswert zuordnen, der Koeffizienten zugeordnet ist, um einen Motor- oder Lüftungsmaskierungsfilter zu definieren,
   - einen Kollektor (210), der so angeordnet ist, dass er mindestens zwei auf dem Kommunikationsbus zugängliche Parameter empfängt, wobei diese Parameter die Geschwindigkeit des Fahrzeugs und mindestens einen Funktionsparameter bezeichnen, der aus der Gruppe ausgewählt ist, die die Motordrehzahl des Fahrzeugs und einen Lüftungsdatensatz umfasst, und
   - ein Steuergerät (220), das so angeordnet ist, dass es an dem Eingang einen Schallpegelwert sowie die mindestens zwei auf dem Kommunikationsbus zugänglichen Parameter empfängt, um daraus mindestens einen Geschwindigkeitsfilter-Datensatz und mindestens einen Funktionsfilter-Datensatz abzuleiten und diese zu einem Maskierungsentzerrungsfilter zu kombinieren, das auf ein Audiosignal anzuwenden ist.

2. Vorrichtung nach Anspruch 1, wobei das Steuergerät (220) für Folgendes angeordnet ist:

   - Bestimmen eines Geschwindigkeitsfilter-Datensatzes und eines Funktionsfilter-Datensatzes in dem Speicher (200) aus den mindestens zwei von dem Kollektor (210) bestimmten Parametern,
   - Berechnen eines Geschwindigkeitsverstärkungswert aus mindestens dem Verstärkungswert des bestimmten Geschwindigkeitsfilter-Datensatzes und dem Schallpegelwert und Ableiten eines Geschwindigkeitsfilter-Datensatzes daraus, und
   - Bestimmen eines Funktionsverstärkungswerts aus mindestens dem Verstärkungswert des bestimmten Funktionsfilter-Datensatzes, dem Geschwindigkeitsverstärkungswert und dem Schallpegelwert und Ableiten eines Funktionsfilter-Datensatzes daraus.

3. Vorrichtung nach Anspruch 2, wobei das Steuergerät (220) so angeordnet ist, dass es den Geschwindigkeitsverstärkungswert berechnet, indem es das Minimum zwischen dem Verstärkungswert des bestimmten Geschwindigkeitsfilter-Datensatzes und dem Schallpegelwert berücksichtigt, und dass es den Funktionsverstärkungswert berechnet, indem es das Minimum zwischen dem Verstärkungswert des bestimmten Funktionsfilter-Datensatzes und der Differenz zwischen dem Schallpegelwert und dem Geschwindigkeitsverstärkungswert berücksichtigt.

4. Vorrichtung nach Anspruch 2 oder 3, wobei das Steuergerät (220) bei Vorhandensein eines Funktionsparameters der Motordrehzahl und eines Funktionsparameters des Lüftungsdatensatzes für Folgendes angeordnet ist:

   - Bestimmen eines Hauptfunktionsfilter-Datensatzes und eines zweiten sekundären Funktionsfilter-Datensatzes aus dem Funktionsparameter der Motordrehzahl und dem Funktionsparameter des Lüftungsdatensatzes, wobei der Verstärkungswert des Hauptfunktionsfilter-Datensatzes größer ist als der Verstärkungswert des sekundären Funktionsfilter-Datensatzes,
   - Bestimmen eines ersten Funktionsverstärkungswerts aus mindestens dem Verstärkungswert des Funktionsfilter-Datensatzes, dem Geschwindigkeitsverstärkungswert und dem Schallpegelwert und Ableiten eines ersten Funktionsfilter-Datensatzes daraus,
   - Bestimmen eines zweiten Funktionsverstärkungswerts aus mindestens dem Verstärkungswert des sekundären Funktionsfilter-Datensatzes, dem Geschwindigkeitsverstärkungswert und dem Schallpegelwert und Ableiten eines zweiten Funktionsfilter-Datensatzes daraus, und

- Berechnen eines Funktionsverstärkungswerts und eines Funktionsfilter-Datensatzes aus dem ersten Funktionsverstärkungswert, dem zweiten Funktionsverstärkungswert, dem ersten Funktionsfilter-Datensatz und dem zweiten Funktionsfilter-Datensatz.

5. Vorrichtung nach Anspruch 1, wobei, wenn der Geschwindigkeitsparameter unter einem ausgewählten Schwellenwert liegt, das Steuergerät (220) für Folgendes angeordnet ist:

- Bestimmen eines Funktionsfilter-Datensatzes und eines Geschwindigkeitsfilter-Datensatzes in dem Speicher (200) aus den mindestens zwei von dem Kollektor (210) bestimmten Parametern,
- Bestimmen eines Funktionsverstärkungswerts aus mindestens dem Verstärkungswert des bestimmten Funktionsfilter-Datensatzes und dem Schallpegelwert und Ableiten eines Funktionsfilter-Datensatzes daraus aus dem Funktionsverstärkungswert, und
- Bestimmen eines Geschwindigkeitsverstärkungswerts aus mindestens dem Verstärkungswert des bestimmten Geschwindigkeitsfilter-Datensatzes, dem Funktionsverstärkungswert und dem Schallpegelwert und Ableiten eines Geschwindigkeitsfilter-Datensatzes daraus aus der Geschwindigkeitsverstärkung.

6. Vorrichtung nach Anspruch 5, wobei das Steuergerät (220) so angeordnet ist, dass es den Funktionsverstärkungswert berechnet, indem es das Minimum zwischen dem Verstärkungswert des bestimmten Funktionsfilterdatensatzes und dem Schallpegelwert berücksichtigt, und dass es den Geschwindigkeitsverstärkungswert berechnet, indem es das Minimum zwischen dem Verstärkungswert des bestimmten Geschwindigkeitsfilter-Datensatzes und der Differenz zwischen dem Schallpegelwert und dem Funktionsverstärkungswert berücksichtigt.

7. Vorrichtung nach Anspruch 5 oder 6, wobei das Steuergerät (220) bei Vorhandensein eines Funktionsparameters der Motordrehzahl und eines Funktionsparameter des Lüftungsdatensatzes für Folgendes angeordnet ist:

- Bestimmen eines Hauptfunktionsfilter-Datensatzes und eines sekundären Funktionsfilter-Datensatzes aus dem Funktionsparameter der Motordrehzahl und dem Funktionsparameter des Lüftungsdatensatzes, wobei der Verstärkungswert des Hauptfunktionsfilter-Datensatzes größer ist als der Verstärkungswert des sekundären Funktionsfilter-Datensatzes,
- Bestimmen eines ersten Funktionsverstärkungswerts aus mindestens dem Verstärkungswert des Funktionsfilter-Datensatzes und dem Schallpegelwert und Ableiten eines ersten Funktionsfilter-Datensatzes daraus,
- Bestimmen eines zweiten Funktionsverstärkungswerts aus mindestens dem Verstärkungswert des sekundären Funktionsfilter-Datensatzes und dem Schallpegelwert und Ableiten eines zweiten Funktionsfilter-Datensatzes daraus, und
- Berechnen eines Funktionsverstärkungswerts und eines Funktionsfilter-Datensatzes aus dem ersten Funktionsverstärkungswert, dem zweiten Funktionsverstärkungswert, dem ersten Funktionsfilter-Datensatz und dem zweiten Funktionsfilter-Datensatz.

8. Vorrichtung nach einem der vorhergehenden Ansprüche, wobei das Steuergerät (220) so angeordnet ist, dass es ein Hochpassfilter auf das Maskierungsentzerrungsfilter in Abhängigkeit von der Differenz zwischen dem Schallpegel, dem Geschwindigkeitsverstärkungswert und dem Funktionsverstärkungswert anwendet.

9. Verfahren zum Entzerren von Audiosignalen für Fahrzeuge, das einen Datenkommunikationsbus einsetzt und Folgendes umfasst:

a) Speichern von Geschwindigkeitsfilter-Datensätzen, die Tripletts umfassen, die einen Geschwindigkeitswert und einen Verstärkungswert zuordnen, der Koeffizienten zugeordnet ist, um einen Geschwindigkeitsmaskierungsfilter zu definieren, und Funktionsfilter-Datensätze speichert, die Tripletts umfassen, die einen Motordrehzahlwert oder einen Belüftungswert und einen Verstärkungswert zuordnen, der Koeffizienten zugeordnet ist, um einen Motor- oder Lüftungsmaskierungsfilter zu definieren,
b) Empfangen von mindestens zwei auf dem Kommunikationsbus zugänglichen Parametern, wobei diese Parameter die Geschwindigkeit des Fahrzeugs und mindestens einen Funktionsparameter, der aus der Gruppe ausgewählt ist, die die Motordrehzahl des Fahrzeugs und einen Lüftungsdatensatz umfasst, und einen Schallpegelwert bezeichnen, und
c) Ableiten, aus Parametern aus Schritt b) und dem Schallpegelwert, mindestens eines Geschwindigkeitsfilter-Datensatzes und mindestens eines Funktionsfilter-Datensatzes und Kombinieren dieser zu einem Maskierungsentzerrungsfilter, das auf ein Audiosignal anzuwenden ist.

**10.** Verfahren zum Entzerren von Audiosignalen nach Anspruch 9, wobei Vorgang c) Folgendes umfasst

c1) Bestimmen eines Geschwindigkeitsfilter-Datensatzes und eines Funktionsfilter-Datensatzes aus den mindestens zwei von dem Kollektor (210) bestimmten Parametern,

c2) Berechnen eines Geschwindigkeitsverstärkungswert aus mindestens dem Verstärkungswert des bestimmten Geschwindigkeitsfilter-Datensatzes und dem Schallpegelwert und Ableiten eines Geschwindigkeitsfilter-Datensatzes daraus, und

c3) Bestimmen eines Funktionsverstärkungswerts aus mindestens dem Verstärkungswert des bestimmten Funktionsfilter-Datensatzes, dem Geschwindigkeitsverstärkungswert und dem Schallpegelwert und Ableiten eines Funktionsfilter-Datensatzes daraus.

**11.** Verfahren zum Entzerren von Audiosignalen nach Anspruch 10, wobei der Vorgang c2) das Berechnen des Geschwindigkeitsverstärkungswerts umfasst, indem das Minimum zwischen dem Verstärkungswert des bestimmten Geschwindigkeitsfilter-Datensatzes und dem Schallpegelwert berücksichtigt wird, und der Vorgang c3) das Berechnen des Funktionsverstärkungswerts umfasst, indem das Minimum zwischen dem Verstärkungswert des bestimmten Funktionsfilter-Datensatzes und der Differenz zwischen dem Schallpegelwert und dem Geschwindigkeitsverstärkungswert berücksichtigt wird.

**12.** Verfahren zum Entzerren von Audiosignalen nach Anspruch 10 oder 11, wobei, wenn der Vorgang b) einen Funktionsparameter der Motordrehzahl und einen Funktionsparameter des Lüftungsdatensatzes zurückgibt, der Vorgang c3) Folgendes umfasst:

c3a) Bestimmen eines Hauptfunktionsfilter-Datensatzes und eines zweiten sekundären Funktionsfilter-Datensatzes aus dem Funktionsparameter der Motordrehzahl und dem Funktionsparameter des Lüftungsdatensatzes, wobei der Verstärkungswert des Hauptfunktionsfilter-Datensatzes größer ist als der Verstärkungswert des sekundären Funktionsfilter-Datensatzes,

c3b) Bestimmen eines ersten Funktionsverstärkungswerts aus mindestens dem Verstärkungswert des Funktionsfilter-Datensatzes, dem Geschwindigkeitsverstärkungswert und dem Schallpegelwert und Ableiten eines ersten Funktionsfilter-Datensatzes daraus,

c3c) Bestimmen eines zweiten Funktionsverstärkungswerts aus mindestens dem Verstärkungswert des sekundären Funktionsfilter-Datensatzes, dem Geschwindigkeitsverstärkungswert und dem Schallpegelwert und Ableiten eines zweiten Funktionsfilter-Datensatzes daraus, und

c3d) Berechnen eines Funktionsverstärkungswerts und eines Funktionsfilter-Datensatzes aus dem ersten Funktionsverstärkungswert, dem zweiten Funktionsverstärkungswert, dem ersten Funktionsfilter-Datensatz und dem zweiten Funktionsfilter-Datensatz.

**13.** Verfahren zum Entzerren von Audiosignalen nach Anspruch 9, wobei, wenn der Geschwindigkeitsparameter des Vorgangs b) unter einem ausgewählten Schwellenwert liegt, der Vorgang c) Folgendes umfasst:

c1) Bestimmen eines Funktionsfilter-Datensatzes und eines Geschwindigkeitsfilter-Datensatzes in dem Speicher (200) aus den mindestens zwei von dem Kollektor (210) bestimmten Parametern,

c2) Bestimmen eines Funktionsverstärkungswerts aus mindestens dem Verstärkungswert des bestimmten Funktionsfilter-Datensatzes und dem Schallpegelwert und Ableiten eines Funktionsfilter-Datensatzes daraus aus dem Funktionsverstärkungswert, und

c3) Bestimmen eines Geschwindigkeitsverstärkungswerts aus mindestens dem Verstärkungswert des bestimmten Geschwindigkeitsfilter-Datensatzes, dem Funktionsverstärkungswert und dem Schallpegelwert und Ableiten eines Geschwindigkeitsfilter-Datensatzes daraus aus der Geschwindigkeitsverstärkung.

**14.** Verfahren zum Entzerren von Audiosignalen nach Anspruch 13, wobei der Vorgang c1) das Berechnen des Funktionsverstärkungswerts umfasst, indem das Minimum zwischen dem Verstärkungswert des bestimmten Funktionsfilter-Datensatzes und dem Schallpegelwert berücksichtigt wird, und der Vorgang c2) das Berechnen des Geschwindigkeitsverstärkungswerts umfasst, indem das Minimum zwischen dem Verstärkungswert des bestimmten Geschwindigkeitsfilter-Datensatzes und der Differenz zwischen dem Schallpegelwert und dem Funktionsverstärkungswert berücksichtigt wird.

**15.** Verfahren zum Entzerren von Audiosignalen nach Anspruch 13 oder 14, wobei, wenn der Vorgang b) einen Funktionsparameter der Motordrehzahl und einen Funktionsparameter des Lüftungsdatensatzes zurückgibt, der Vorgang c2) Folgendes umfasst:

c2a) Bestimmen eines Hauptfunktionsfilter-Datensatzes und eines sekundären Funktionsfilter-Datensatzes aus dem Funktionsparameter der Motordrehzahl und dem Funktionsparameter des Lüftungsdatensatzes, wobei der Verstärkungswert des Hauptfunktionsfilter-Datensatzes größer ist als der Verstärkungswert des sekundären Funktionsfilter-Datensatzes,

c2b) Bestimmen eines ersten Funktionsverstärkungswerts aus mindestens dem Verstärkungswert des Funktionsfilter-Datensatzes und dem Schallpegelwert und Ableiten eines ersten Funktionsfilter-Datensatzes daraus,

c2c) Bestimmen eines zweiten Funktionsverstärkungswerts aus mindestens dem Verstärkungswert des sekundären Funktionsfilter-Datensatzes und dem Schallpegelwert und Ableiten eines zweiten Funktionsfilter-Datensatzes daraus, und

c2d) Berechnen eines Funktionsverstärkungswerts und eines Funktionsfilter-Datensatzes aus dem ersten Funktionsverstärkungswert, dem zweiten Funktionsverstärkungswert, dem ersten Funktionsfilter-Datensatz und dem zweiten Funktionsfilter-Datensatz.

16. Verfahren zum Entzerren von Audiosignalen nach einem der Ansprüche 9 bis 15, ferner umfassend den Schritt d) des Anwendens eines Hochpassfilters auf das Maskierungsentzerrungsfilter in Abhängigkeit von der Differenz zwischen dem Schallpegel, dem Geschwindigkeitsverstärkungswert und dem Funktionsverstärkungswert.

17. Computerimplementiertes Programm, das Anweisungen zum Ausführen des Verfahrens nach einem der Ansprüche 9 bis 16 umfasst.

18. Datenspeichermedium, auf dem das Computerprogramm nach Anspruch 17 gespeichert ist.

**Claims**

1. Audio-signal equalisation device for a vehicle using a data communication bus, comprising:

   - a memory (200) arranged to store sets of speed filter data comprising triplets associating a speed value of the vehicle (V) and a gain value associated with coefficients for defining a speed masking filter, and functional filter data sets comprising triplets associating an engine speed value (rpm) or a ventilation value (HVAC[]) and a gain value associated with coefficients for defining an engine or ventilation masking filter,
   - a collector (210) arranged to receive at least two parameters accessible on the communication bus, said parameters designating the speed of the vehicle (V) and at least one functional parameter selected from the group comprising the engine speed of the vehicle (rpm) and a ventilation data set (HVAC[]), and
   - a computer (220) arranged to receive as an input a noise margin value (HR), as well as said at least two parameters accessible on the communication bus, to derive therefrom at least one speed filter data set (FV)[] and at least one functional filter data set (FP[]) and to combine them into a masking equalisation filter (MF) to be applied to the audio signal.

2. Device according to claim 1, wherein the computer (220) is arranged:

   - to determine the speed filter data set and the functional filter data set in the memory (200) from the at least two parameters determined by the collector (210),
   - to calculate a speed gain value (GV) from at least the gain value of the speed filter data set determined and the noise margin value and to derive therefrom a speed filter data set, and
   - to determine a functional gain value (GP) from at least the gain value of the functional filter data set determined, the speed gain value and the noise margin value, and to derive therefrom the functional filter data set.

3. Device according to claim 2, wherein the computer (220) is arranged to calculate the speed gain value from the minimum between the gain value of the speed filter data set determined and the noise margin value, and to calculate the functional gain value from the minimum between the gain value of the functional filter data set determined and the difference between the noise margin value and the speed gain value.

4. Device according to claim 2 or 3, wherein the computer (220) is arranged, in the presence of an engine speed functional parameter and a ventilation data set functional parameter:

   - to determine a principal functional filter data set and a second secondary functional filter data set from the engine speed function parameter and the ventilation data set functional parameter, the gain value of the principal functional filter data set being greater than the gain value of the secondary functional filter data set,
- to determine a first functional gain value from at least the gain value of the principal functional filter data set, the speed gain value and the noise margin value, and to derive therefrom a first functional filter data set,
- to determine a second functional gain value from at least the gain value of the secondary functional filter data set, the first functional gain value, the speed gain value and from the noise margin value and to derive therefrom a second functional filter data set, and
- to calculate a functional gain value and the functional filter data set from the first functional gain value, the second functional gain value, the first functional filter data set and the second functional filter data set.

5. Device according to claim 1, wherein the computer (220) is arranged, when the speed parameter is below a selected threshold:

- to determine the functional filter data set and the speed filter data set in the memory (200) from the at least two parameters determined by the collector (210)
- to determine a functional gain value from at least the gain value of the functional filter data set determined and the noise margin value, and to derive therefrom the functional filter data set from the functional gain value, and
- to determine a speed gain value from at least the gain value of the speed filter data set determined, the functional gain value and the noise margin value, and to derive therefrom the speed filter data set from the speed gain.

6. Device according to claim 5, wherein the computer (220) is arranged to calculate the functional gain value by retaining the minimum between the gain value of the functional filter data set determined and the noise margin value, and to calculate the speed gain value by retaining the minimum between the gain value of the speed filter data set determined and the difference between the noise margin value and the functional gain value.

7. Device according to claim 5 or 6, wherein the computer (220) is arranged, in the presence of an engine speed functional parameter and a ventilation-data set functional parameter:

- to determine a principal functional filter data set and a secondary functional filter data set from the engine speed functional parameter and the ventilation data set functional parameter, the gain value of the principal functional filter data set being greater than the gain value of the secondary functional filter data set,
- to determine a first functional gain value from at least the gain value of the principal functional filter data set and the noise margin value, and to derive therefrom a first functional filter data set,
- to determine a second functional gain value from at least the gain value of the secondary functional filter data set, the first functional gain value and the noise margin value, and to derive therefrom a second functional filter data set, and
- to calculate a functional gain value and the functional filter data set from the first functional gain value, the second functional gain value, the first functional filter data set and the second functional filter data set.

8. Device according to one of the preceding claims, wherein the computer (220) is arranged to apply a high-pass filter to the masking equalisation filter according to the difference between the noise margin, the speed gain value and the functional gain value.

9. Audio-signal equalisation method for a vehicle using a data communication bus, comprising:

a) storing sets of speed filter data comprising triplets associating a speed value of the vehicle and a gain value associated with coefficients for defining a speed masking filter, and functional filter data sets comprising triplets associating an engine speed value or a ventilation value and a gain value associated with coefficients for defining an engine or ventilation masking filter,
b) receiving at least two parameters accessible on the data communication bus, said parameters designating the speed of the vehicle and at least one functional parameter selected from the group comprising the engine speed of the vehicle and a ventilation data set, and a noise margin value, and
c) deriving, from the parameters of step b) and the noise margin value, at least one speed filter data set and at least one functional filter data set, and to combine them in a masking equalisation filter to be applied to an audio signal.

10. Audio-signal equalisation method according to claim 9, wherein the operation c) comprises

c1) determining the speed filter data set and the functional filter data set from the at least two parameters determined by the collector (210),

c2) calculating a speed gain value from at least the gain value of the speed filter data set determined and the noise margin value, and deriving therefrom the speed filter data set, and

c3) determining a functional gain value from at least the gain value of the functional filter data set determined, the speed gain value and the noise margin value, and deriving therefrom the functional filter data set.

11. Audio-signal equalisation method according to claim 10, wherein operation c2) comprises calculating the speed gain value from the minimum between the gain value of the speed filter data set determined, the noise margin value, and operation c3) comprises calculating the functional gain value from the minimum between the gain value of the functional filter data set determined, the difference between the noise margin value and the speed gain value.

12. Audio-signal equalisation method according to claim 10 or 11, wherein, when operation b) returns an engine speed functional parameter and a ventilation data set functional parameter, operation c3) comprises:

c3a) determining a principal functional filter data set and a second secondary functional filter data set from the engine speed functional parameter and the ventilation data set functional parameter, the gain value of the principal functional filter data set being greater than the gain value of the secondary functional filter data set,

c3b) determining a first functional gain value from at least the gain value of the principal functional filter data set, the speed gain value and the noise margin value, and deriving therefrom a first functional filter data set,

c3c) determining a second functional gain value from at least the gain value of the secondary functional filter data set, the first functional gain value, the speed gain value and the noise margin value, and deriving therefrom a second functional filter data set, and

c3d) calculating a functional gain value and the functional filter data set from the first functional gain value, the second functional gain value, the first functional filter data set and the second functional filter data set.

13. Audio-signal equalisation method according to claim 9, wherein, when the speed parameter of operation b) is below a selected threshold, operation c) comprises:

c1) determining the functional filter data set and the speed filter data set in the memory (200) from the at least two parameters determined by the collector (210),

c2) determining a functional gain value from at least the gain value of the functional filter data set determined and the noise margin value, and deriving therefrom a functional filter data set from the functional gain value, and

c3) determining a speed gain value from at least the gain value of the speed filter data set determined, the functional gain value and the noise margin value, and deriving therefrom the speed filter data set from the speed gain.

14. Audio-signal equalisation method according to claim 13, wherein operation c1) comprises calculating the functional gain value from the minimum between the gain value of the functional filter data set determined, the noise margin value, and operation c2) comprises calculating the speed gain value from the minimum between the gain value of the speed filter data set determined, the difference between the noise margin value and the functional gain value.

15. Audio-signal equalisation method according to claim 13 or 14, wherein, when operation b) returns an engine speed functional parameter and a ventilation data set functional parameter, operation c2) comprises:

c2a) determining a principal functional filter data set and a secondary functional filter data set from the engine speed functional parameter and the ventilation data set functional parameter, the gain value of the principal functional filter data set being greater than the gain value of the secondary functional filter data set,

c2b) determining a first functional gain value from at least the gain value of the principal functional filter data set and the noise margin value, and deriving therefrom a first functional filter data set,

c2c) determining a second functional gain value from at least the gain value of the secondary functional filter data set, the first functional gain value and the noise margin value, and deriving therefrom a second functional filter data set, and

c2d) calculating a functional gain value and the functional filter data set from the first functional gain value, the second functional gain value, the first functional filter data set and the second functional filter data set.

16. Audio-signal equalisation method according to one of claims 9 to 15, furthermore comprising the operation d) of applying a high-pass filter to the masking equalisation filter function according to the difference between the noise margin, the speed gain value and the functional gain value.

17. Computer programme used by a computer comprising instructions for executing the method according to one of claims 9 to 16.

18. Data storage medium on which the computer program according to claim 17 is recorded.

[Fig. 1]

112   100

114

110

[Fig. 2]

210

200

220

[Fig. 3]

```
┌─────────────────────────────┐
│      (V;rpm;HVAC[];HR)       │  300
└─────────────────────────────┘
               │
               ▼
┌─────────────────────────────┐
│       (G;F[]) = Filt1(V)     │  310
└─────────────────────────────┘
               │
               ▼
┌─────────────────────────────┐
│        LSG = Min(G;HR)       │  320
└─────────────────────────────┘
               │
               ▼
┌─────────────────────────────┐
│    (GV;FV[]) = Filt2(LSG;vit)│  330
└─────────────────────────────┘
               │
               ▼
┌─────────────────────────────┐
│   (G;F[]) = Filt(rpm;HVAC[]) │  340
└─────────────────────────────┘
               │
               ▼
┌─────────────────────────────┐
│       P = Min(G;HR-GV)       │  350
└─────────────────────────────┘
               │
               ▼
┌─────────────────────────────┐
│    (GP;FP[]) = Filt2(P;par)  │  360
└─────────────────────────────┘
               │
               ▼
┌─────────────────────────────┐
│  MF = Comb(GV;FV[];GP:FP[])  │  370
└─────────────────────────────┘
               │
               ▼
┌ ─ ─ ─ ─ ─ ─ ─ ─ ─ ─ ─ ─ ─ ─ ┐
│       MF = HPF(MF)           │  380
└ ─ ─ ─ ─ ─ ─ ─ ─ ─ ─ ─ ─ ─ ─ ┘
```

[Fig. 4]

[Fig. 5]

[Fig. 6]

643 Hz : -8.56 dB

[Fig. 7]

```
                    ┌──────────────────────────┐
                    │   (V;rpm;HVAC[];HR)      │ 700
                    └──────────────────────────┘
                                │
                              705│
                                ▼
                          ◇─────────────◇              ┌──────────┐
                          ◇   V < Vm?   ◇─────────────▶│  Reg()   │ 709
                          ◇─────────────◇              └──────────┘
                                │
                                ▼
        ┌──────────────────────────────────────────────┐
        │ (Gmax;Fmax[];Gmin;Fmin[]) = Filt3(rmp;HVAC[]) │ 710
        └──────────────────────────────────────────────┘
                                │
                                ▼
                    ┌──────────────────────────┐
                    │   PG1 = Min(Gmax;HR)      │ 720
                    └──────────────────────────┘
                                │
                                ▼
                    ┌──────────────────────────┐
                    │   (GP1;FP1[]) = Filt2(PG1) │ 722
                    └──────────────────────────┘
                                │
                                ▼
                    ┌──────────────────────────┐
                    │   PG2 = Min(Gmin;HR-PG1)  │ 724
                    └──────────────────────────┘
                                │
                                ▼
                    ┌──────────────────────────┐
                    │   (GP2;FP2[]) = Filt2(PG2) │ 726
                    └──────────────────────────┘
                                │
                                ▼
        ┌──────────────────────────────────────────────┐
        │ (PG;FP[])= Comb(GP1;FP1[];GP2:FP2[])          │ 730
        └──────────────────────────────────────────────┘
                                │
                                ▼
                    ┌──────────────────────────┐
                    │   (G;F[]) = Filt1(V)      │ 740
                    └──────────────────────────┘
                                │
                                ▼
                    ┌──────────────────────────┐
                    │   LSG = Min(G-PG;HR-PG)   │ 750
                    └──────────────────────────┘
                                │
                                ▼
                    ┌──────────────────────────┐
                    │   (GV;FV[]) = Filt2(LSG)  │ 760
                    └──────────────────────────┘
                                │
                                ▼
                    ┌──────────────────────────┐
                    │   MF = Comb(GV;FV[];GP:FP[]) │ 770
                    └──────────────────────────┘
                                │
                                ▼
                    ┌ ─ ─ ─ ─ ─ ─ ─ ─ ─ ─ ─ ─ ┐
                    │   MF = HPF(MF)            │ 780
                    └ ─ ─ ─ ─ ─ ─ ─ ─ ─ ─ ─ ─ ┘
```

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2005213776 A1
- EP 2693636 A1

- FR 2211921